# EUROPEAN PATENT APPLICATION

(11) **EP 4 645 704 A1**
(43) Date of publication of application: **05.11.2025**
(21) Application number: 24305678.5
(22) Date of filing: 30.04.2024
(51) Int. Cl.: H03M 1/74, H03K 19/173, H03K 19/017, H03K 19/0948

(54) **A LOGIC CONTROL CIRCUIT FOR USE IN A DIGITAL-TO-ANALOG CONVERTER**

(71) Applicant: Scalinx, 75013 Paris (FR)
(72) Inventor: GUIRAUD, Lionel, 14750 St Aubin Sur Mer (FR)
(74) Representative: Murgitroyd & Company

(57) **Abstract**

A logic control circuit for a digital-to-analog converter, comprising: a first logic cell and a second logic cell each comprising: a first input terminal, a second input terminal and an output terminal; a first transistor and a second transistor both of a first carrier type, wherein the first transistor and the second transistor are connected in parallel; and a third transistor of a second carrier type opposite to the first carrier type; wherein the drain terminals of the first transistor, the second transistor, and the third transistor are connected to the output terminal; and a fourth transistor of the second carrier type connected in series with the third transistors of the first logic cell and the second logic cell such that the first logic cell and the fourth transistor form a first logic gate and the second logic cell and the fourth transistor form a second logic gate.

## Description

### Field of the invention

This invention relates to a logic control circuit for controlling current steering switches of a digital-to-analog converter (DAC), in particular a logic control circuit for generating logic control signals configured to control one or more differential switch pairs in a DAC.

### Background to the invention

A digital-to-analog converter (DAC) is an electronic device that converts a digital signal into an analog signal. Among various types of DACs, current steering DACs are a very popular type because they provide higher resolution with less power consumption. A current steering DAC generally comprises one or more current steering units each comprising a current source followed by a differential switch pair and a load. In each current steering unit, the differential switch pair is controlled by one logic control signal (which may be set to 1 or 0) and its inverted signal and is operable to steer a current from the current source to the load. The number of the current steering units depends on the number of bits of the DAC. Typically, the differential output voltage has either a strictly negative output voltage value (e.g., a logic state "0" may lead to a negative output voltage value -V) or a strictly positive output voltage (e.g., a logic state "1" may lead to a positive output voltage value +V).

However, in many applications, it is desirable that the differential output voltage of a differential switch pair has an output voltage value of zero. This can be achieved by using the return-to-zero (RTZ) DAC architecture or the multi-path DAC architecture. Further information about these DAC architectures can be found in US6061010, US7796971B2 or US10644716B1, which are incorporated herein by reference. In either the RTZ or multipath architecture, a current steering unit comprises two parallelly-connected differential switch pairs connected to a common current source. In such an implementation, only one of the two parallelly connected differential switch pairs steers a current from the current source to the load at any time instance. Thus, instead of controlling the two inputs of the differential pair with a logic control signal and its inverted signal, there is a need to set both input logic control signals to 0. A set of logic cells (e.g. two OR gates) may be used to generate such logic control signals, e.g., as taught in US7796971B2 and US10644716B1.

The switching speed of these logic gates is crucial to meet the demand for the continuously increasing data rate and resolution (or the number of bits) of DACs. Each additional bit increases by a factor of two the number (in the case of the thermometer-coded configuration) or the size (in the case of the binary-weighted configuration) of the current steering units, which results in a factor of two increase in the load that the logic cells have to drive.

Objects and aspects of the present claimed invention seek to alleviate at least these problems with the prior art.

### Summary of the invention

Aspects of the present disclosure are set out in the accompanying independent and dependent claims. Combinations of features from the dependent claims may be combined with features of the independent claims as appropriate and not merely as explicitly set out in the claims.

According to a first aspect of the present invention, there is provided a logic control circuit for controlling current steering switches of a digital-to-analog converter (DAC). The logic control circuit may comprise a first logic cell and a second logic cell. Each of the first logic cell and the second logic cell may comprise a first input terminal and a second input terminal for receiving input digital signals and an output terminal for outputting a logic control signal. Each of the first logic cell and the second logic cell may comprise a first transistor and a second transistor, both of which may be a first carrier type (e.g., N-type or P-type). The first transistor and the second transistor may be connected in parallel. Each of the first logic cell and the second logic cell may comprise a third transistor of a second carrier type (e.g., P-type or N-type) which may be opposite to the first carrier type. The drain terminals of the first transistor, the second transistor, and the third transistor may be connected to the output terminal. The logic control circuit may comprise a fourth transistor of the second carrier type which may be connected to both the first logic cell and the second logic cell. The fourth transistor may be in series with the third transistor of the first logic cell and the third transistor of the second logic cell such that the first logic cell and the fourth transistor may form a first logic gate, and the second logic cell and the fourth transistor may form a second logic gate of the same type as the first logic gate.

The proposed logic control circuit solves the problems with the prior art by adopting an innovative circuit design which is capable of providing a same number of logic control signals as the prior art logic control circuit with a reduced number of transistors. This may be achieved by merging some of the transistors of the prior art logic control circuit. Here, the term "merging" may refer to replacing two or more transistors with a single transistor while simultaneously maintaining the functionality of the logic control circuit. Reducing the total number of transistors of a logic control circuit intrinsically reduces the load of the logic control circuit and therefore leads to a faster switching speed.

In an embodiment, the first input terminal of the first logic cell may be operable to receive a first input digital signal; the first input terminal of the second logic cell may be operable to receive a second input digital signal different than the first input digital signal; and the second input terminal of the first logic cell and the second input terminal of the second logic cell may be both connected to form a common terminal operable to receive a third input digital signal. The third digital input signal may be for example a clock signal.

In an embodiment, the first input digital signal and the second input digital signal may be of opposite logic states.

In an embodiment, the drain terminal of the fourth transistor may be connected to the source terminal of the third transistor of the first logic cell and to the source terminal of the third transistor of the second logic cell.

In an embodiment, the gate terminals of the first transistor and the fourth transistor of the first logic cell may be connected to the second input terminal of the first logic cell and the gate terminals of the first transistor and the fourth transistor of the second logic cell may be connected to the second input terminal of the second logic cell; and the gate terminals of the second transistor and the third transistor of the first logic cell may be connected to the first input terminal of the first logic cell and the gate terminals of the second transistor and the third transistor of the second logic cell may be connected to the first input terminal of the second logic cell.

In an embodiment, the first carrier type may be P-type and the second carrier type may be N-type. In an embodiment, the source terminal of the fourth transistor may be connected to a ground terminal. In an embodiment, the source terminals of the first transistor and the second transistor of the first logic cell, and the source terminals of the first transistor and the second transistor of the second logic cell may be connected to a positive power supply terminal. In an embodiment, the first logic gate and the second logic gate may be both a NAND gate.

In an embodiment, the first carrier type may be N-type and the second carrier type may be P-type. In an embodiment, the source terminal of the fourth transistor may be connected to a positive power supply terminal. In an embodiment, the source terminals of the first transistor and the second transistor of the first logic cell and the source terminals of the first transistor and the second transistor of the second logic cell may be connected to a ground terminal. In an embodiment, the first logic gate and the second logic gate may be both a NOR gate.

In an embodiment, the fourth transistor and the third transistors of the first logic cell and the second logic cell may be of a same size.

In an embodiment, the first transistor, the second transistor, the third transistor and the fourth transistor of each of the first logic cell and the second logic cell may be metal-oxide-semiconductor field-effect transistors (MOSFETs).

According to a second aspect of the present invention, there is provided a digital-to-analog converter (DAC). The DAC may comprise a plurality of current steering switches configured to convert an input digital signal to an output analog signal; and a control circuit comprising at least one logic control circuit as claimed in any preceding claim, wherein based on the input digital signal, each of the at least one logic control circuit is operable to output two logic control signals configured to control at least some of the plurality of current steering switches to output the corresponding analog signal.

In an embodiment, the plurality of current steering switches may be arranged into a plurality of differential switch pairs configured to steer a current from a current source to a load; and wherein the two logic control signals of each of at least one logic control circuit may be configured to control one differential switch pair.

In an embodiment, the plurality of differential switch pairs may be arranged into one or more pairs of parallelly connected differential switch pairs; and wherein each pair of parallelly connected differential switch pairs may be connected to a current source and operable to steer a current from the current source to an output of one of the two differential switch pairs.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

### Brief Description of the Drawings

Embodiments of the present disclosure will be described hereinafter, by way of example only, with reference to the accompanying drawings in which like reference signs relate to like elements and in which:
Figure 1A shows a schematic diagram of current steering units of a prior art binary-weighted DAC;
Figure 1B shows a schematic diagram of current steering units of a prior art thermometer-coded DAC;
Figure 2 shows a schematic diagram of a prior art electronic circuit comprising two parallelly-connected differential switch pairs for processing digital data signals having amplitudes represented by one bit;
Figure 3A shows a schematic diagram of a prior art logic control circuit formed with two complete logic NAND gates for generating two logic control signals configured to control a differential switch pair (e.g., one of the two parallelly connected differential switch pairs shown in Figure 2) in a DAC (e.g., a RTZ or multipath DAC);
Figure 3B shows a schematic diagram of a proposed logic control circuit configured to perform the same function as the prior art logic control circuit of Figure 3A but with a reduced number of transistors, in accordance with an embodiment;
Figure 4A shows a schematic diagram of a prior art logic control circuit formed with two complete logic NOR gates for generating two logic control signals configured to control a differential switch pair (e.g., one of the two parallelly connected differential switch pairs shown in Figure 2) in a DAC (e.g., a RTZ or multipath DAC); and
Figure 4B shows a schematic diagram of a proposed logic control circuit configured to perform the same function as the prior art logic control circuit of Figure 4A but with a reduced number of transistors, in accordance with an embodiment.

### Detailed Description

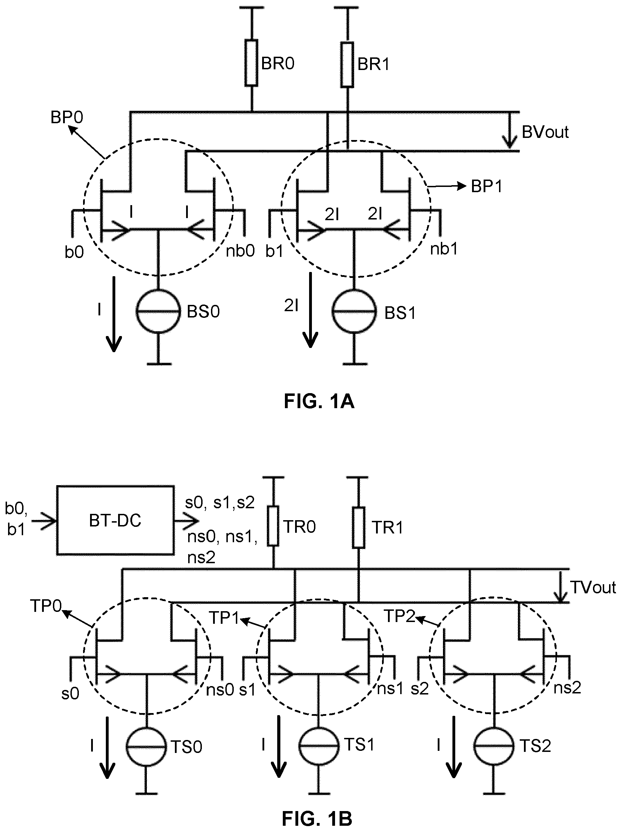

Figures 1A and 1B show two different current steering DAC configurations, namely the binary-weighted configuration and the thermometer-coded configuration, respectively. As shown in Figure 1A, in the binary-weighted configuration, each bit (e.g., b0, b1..., bn) controls a current steering unit comprising a current source BS0 or BS1 (BS0 is part of one current steering unit and BS1 is part of another current steering unit) and a differential switch pair BP0 or BP1 (BP0 is part of one current steering unit and BP1 is part of another current steering unit). The load BR0 and load BR1 are common to all current steering units. The value (e.g., 2⁰*I*, 2¹*I* ... 2*ⁿI*) of the current source BS0, BS1 associated with the current steering unit depends on the weight of the associated bit (e.g., *b*0 = 2°, *b*1 = 2¹*..., bn* = 2*ⁿ*). Accordingly, the value (2¹*I*) of the current source BS1 associated with bit b1 is two times higher than the value (*I*) of the current source BS0 associated with bit b0.

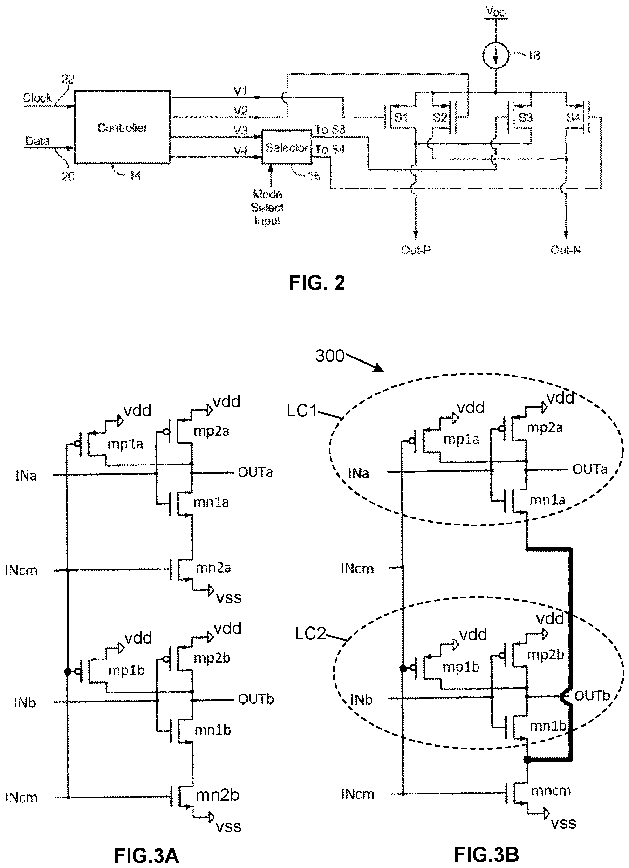

As shown in Figure 1B, in the thermometer-coded configuration, input binary bits (e.g., b0, b1..., bn) are first decoded into thermometer bits (s0, s1, s2..., sn) via a binary to thermometer decoder BT-DC. Each thermometer bit is then used to control an identical current steering unit comprising a current source TS0 or TS1 or TS2 (TS0, TS1 and TS2 are part of three different current steering units, respectively) and a differential switch pair TP0 or TP1 or TP2 (TP0, TP1, TP2 are part of three different current steering units, respectively). The load TR0 and load TR1 are common to all current steering units. The weight of a binary bit is defined by associating a corresponding number of the identical current steering units to the bit. For example, bit b1 controls a group of two (*b*1 = 2¹) identical current steering units that are connected in parallel. Note that bits nb0, nb1, ns0, ns1, ns2 shown in Figures 1A and 2B are inverted bits corresponding to b0, b1, s0, s1, and s2, respectively.

For each differential switch pair shown in Figure 1A or 1B, a logic control signal (which may be either a binary bit or a thermometer bit) and its inverted signal are applied respectively on both sides of the pair. Each differential switch pair BP0, BP1, TP0, TP1, TP2 is operable to steer the current from a corresponding current source BS0, BS1, TS0, TS1, TS2 into a load BR0, BR1, TR0, TR1, which transforms the current into a differential output voltage BVout, TVout. The differential output voltage BVout, TVout has either a strictly positive output voltage value (e.g., a logic state "0" may lead to a negative output voltage value -V) or a strictly positive output voltage (e.g., a logic state "1" may lead to a positive output voltage value +V).

Figure 2 is a reproduction of Figure 3 of US779691B2 which shows a prior art multipath DAC architecture where a current steering unit comprises two parallelly-connected differential switch pairs, i.e. the pair S1 and S2 and the pair S3 and S4, both of which are connected to the current source 18. In operation, if V1 and V2 are both set to 1 and V4 is set to a value opposite to V3, then only the differential switch pair S3 and S4 will steer the current from the current source 18 to either the output node Out-N or the output node Out-P. Similarly, if V3 and V4 are both set to 1 and V2 is set to a value opposite to V1, then only the differential switch pair S1 and S2 will steer the current from the current source 18 to either the output node Out-P or the output node Out-N. Thus, both input logic control signals of each current steering unit need to be set independently to either 1 or 0. In this particular case, two complete logic OR gates are used to generate two logic control signals, V1 and V2, or V3 and V4. In other cases, two complete logic gates of a different type (e.g., logic AND gates, logic NAND gates, or logic NOR gates) may be used to generate logic control signals for each of the two parallelly connected differential switch pairs.

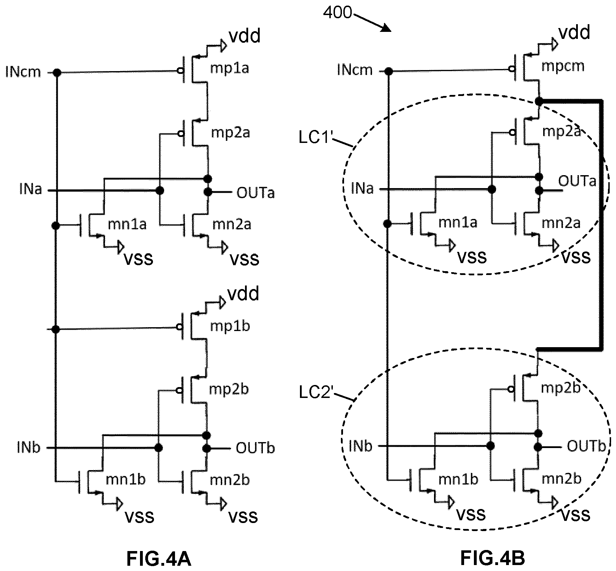

Figures 3A and 4A respectively show a prior art logic control circuit formed with two complete logic NAND gates and a prior art logic control circuit based on two complete logic NOR gates, both configured to generate two logic control signals for controlling a differential switch pair in a DAC (e.g., one of the two parallelly connected differential switch pairs shown in Figure 2).

With reference to Figure 3A, the logic control circuit is formed with a first logic NAND gate and a second logic NAND gate each consisting of four transistors (e.g., metal-oxide-semiconductor field-effect transistors (MOSFETs)). Specifically, the first logic NAND gate (i.e. the upper part of the circuit) consists of a first P-type transistor mp1a and a second P-type transistor mp2a that are connected in parallel, and a first N-type transistor mn1a and a second N-type transistor mn2a that are connected in series. The source terminals of the parallelly connected P-type transistors mp1a, mp2a are both connected to a positive power supply terminal vdd. The drain terminals of the parallelly connected P-type transistors mp1a, mp2a and the drain terminal of the first N-type transistor mn1a are all connected to a first output terminal OUTa of the logic control circuit. The source terminal of the first N-type transistor mn1a is connected to the drain terminal of the second N-type transistor mn2a. The source terminal of the second N-type transistor mn2a is connected to a ground terminal vss. The first logic NAND gate consists of a first input terminal INa connected to the gate terminals of the second P-type transistor mp2a and the first N-type transistor mn1a and a second input terminal INcm connected to the first P-type transistor mp1a and the second N-type transistor mn2a.

Similarly, the second logic NAND gate (i.e. the lower half of the circuit) consists of a first P-type transistor mp1b and a second P-type transistor mp2b that are connected in parallel, and a first N-type transistor mn1b and a second N-type transistor mn2b that are connected in series. The source terminals of the parallelly connected P-type transistors mp1b, mp2b are both connected to a positive power supply terminal vdd. The drain terminals of the parallelly connected P-type transistors mp1b, mp2b and the drain terminal of the first N-type transistor mn1b are all connected to a second output terminal OUTb of the logic control circuit. The source terminal of the first N-type transistor mn1b is connected to the drain terminal of the second N-type transistor mn2b. The source terminal of the second N-type transistor mn2b is connected to a ground terminal vss. The second logic NAND gate consists of a first input terminal INb connected to the gate terminals of the second P-type transistor mp2b and the first N-type transistor mn1b and a second input terminal INcm connected to the first P-type transistor mp1b and the second N-type transistor mn2b. The second input terminals INcm of the first logic NAND gate and the second logic NAND gate are connected to receive a common input.

With reference to Figure 4A, the logic control circuit is formed with a first logic NOR gate and a second logic NOR gate each consisting of four transistors (e.g., metal-oxide-semiconductor field-effect transistors (MOSFETs)). Specifically, the first logic NOR gate (i.e. the upper part of the circuit) consists of a first P-type transistor mp1a and a second P-type transistor mp2a that are connected in series, and a first N-type transistor mn1a and a second N-type transistor mn2a that are connected in parallel. The source terminal of the first P-type transistors mp1a is connected to a positive power supply terminal vdd. The drain terminal of the first P-type transistor mp1a is connected to the source terminal of the second P-type transistor mp2a. The drain terminal of the second P-type transistor mp2a and the drain terminals of the parallelly connected N-type transistors mn1a, mn2a are all connected to a first output terminal OUTa of the logic control circuit. The source terminals of the parallelly connected N-type transistors mn1a, mn2a are both connected to a ground terminal vss. The first logic NOR gate consists of a first input terminal INa connected to the gate terminals of the second P-type transistor mp2a and the second N-type transistor mn2a and a second input terminal INcm connected to the first P-type transistor mp1a and the first N-type transistor mn1a.

Similarly, the second logic NOR gate (i.e. the lower part of the circuit) consists of a first P-type transistor mp1b and a second P-type transistor mp2b that are connected in series, and a first N-type transistor mn1b and a second N-type transistor mn2b that are connected in parallel. The source terminal of the first P-type transistors mp1b is connected to a positive power supply terminal vdd. The drain terminal of the first P-type transistor mp1b is connected to the source terminal of the second P-type transistor mp2b. The drain terminal of the second P-type transistor mp2b and the drain terminals of the parallelly connected N-type transistors mn1b, mn2b are all connected to a second output terminal OUTb of the logic control circuit. The source terminals of the parallelly connected N-type transistors mn1b, mn2b are both connected to a ground terminal vss. The second logic NOR gate consists of a first input terminal INb connected to the gate terminals of the second P-type transistor mp2b and the second N-type transistor mn2b and a second input terminal INcm connected to the first P-type transistor mp1b and the first N-type transistor mn1b. The second input terminals INcm of the first logic NOR gate and the second logic NOR gate are connected to receive a common input.

In either logic control circuit as shown in Figure 3A or 4A, there comprises four inputs (e.g., INa, INcm, INb, INcm) and two outputs (e.g., OUTa, OUTb). However, the four inputs of the pair of logic gates (e.g., NAND or NOR gates) receive only three (instead of four) different input signals and generate only three (instead of four) different combinations of logic output signals (see Table 1). The common input generally receives a clock signal. The state of this common input allows the outputs to reflect the states of the two other inputs or forces both the outputs to a logic 0 or 1. **Error! Reference source not found.**Table 1 below shows an example truth table of the prior art logic control circuit formed with two logic NAND gates, as shown in Figure 3A. The truth table of the prior art circuit shown in Figure 4A is similar to that shown in Table 1.

**Table 1**

| Truth Table | | INa (INb = I̅N̅a̅) | |
|---|---|---|---|
| | | 0 | 1 |
| INcm | 0 | (1, 1) | (1, 1) |
| | 1 | (1, 0) | (0, 1) |

Figures 3B and 4B are associated with embodiments of a proposed logic control circuit for controlling a differential switch pair (e.g., one of the two parallelly connected differential switch pairs shown in Figure 2) in a DAC (e.g., a RTZ or multipath DAC). The proposed logic control circuit may comprise: a first logic cell and a second logic cell, each of the first logic cell and the second logic cell comprising: a first input terminal and a second input terminal for receiving input digital signals and an output terminal for outputting logic control signals; a first transistor and a second transistor both of a first carrier type (N-type or P-type), wherein the first transistor and the second transistor are connected in parallel; and a third transistor of a second carrier type (P-type or N-type), the second carrier type being opposite to the first carrier type; wherein the drain terminals of the first transistor, the second transistor, and the third transistor are connected to the output terminal; and a fourth transistor of the second carrier type connected to both the first logic cell and the second logic cell; wherein the fourth transistor is in series with the third transistor of the first logic cell and the third transistor of the second logic cell such that the first logic cell and the fourth transistor form a first logic gate, and the second logic cell and the fourth transistor form a second logic gate of the same type as the first logic gate.

The proposed logic control circuit takes advantage of the reduced input and output combinations to simplify the implementation and thus enhance the speed of the circuit. The simplified logic control circuit may be achieved by merging two or more transistors into a single transistor. As such, the total number of transistors of the logic control circuit is reduced; it also means the size of the replacing (or merging) transistor is significantly smaller than the sum of the sizes of the transistors that have been replaced. In some cases, the size of the replacing transistor may be equal to or smaller than one half of the sum of the sizes of the transistors that have been replaced. For example, the replacing transistor and the transistors that have been replaced are of a same size. The reduced total number of transistors together with the reduced transistor size lead to a reduced parasitic capacitance and increased switching speed. The single transistor of concern may be the one in the series configuration and may be connected to the common input and directly to the supply or ground.

Figure 3B shows an embodiment 300 of the proposed logic control circuit. In this embodiment. In contrast to the prior art circuit shown in Figure 3A where eight transistors are used to form two logic NAND gates that generate three output combinations, the logic control circuit 300 is capable of providing the same output combinations (see for example Table 1) with only seven transistors and a reduced size to the benefit of switching speed.

With reference to Figure 3B, the logic control circuit 300 comprises a first logic cell LC1 and a second logic cell LC2. The first logic cell LC1 comprises a first input terminal INa and a second input terminal INcm both for receiving input digital signals and a first output terminal OUTa for outputting logic control signals. The first logic cell LC1 comprises a first transistor of P-type mp1a and a second transistor of P-type mp2a which are connected in parallel, and a third transistor of N-type mn1a. The drain terminals of the first transistor mp1a, the second transistor mp2a, and the third transistor mn1a are connected to the first output terminal OUTa. The second logic cell LC2 comprises a first input terminal INb and a second input terminal INcm both for receiving input digital signals and a second output terminal OUTb for outputting logic control signals. The second logic cell LC2 comprises a first transistor of P-type mp1b and a second transistor of P-type mp2b which are connected in parallel, and a third transistor of N-type mn1b. The drain terminals of the first transistor mp1b, the second transistor mp2b, and the third transistor mn1b are connected to the second output terminal OUTb. The second input terminal INcm of the first logic cell LC1 and the second input terminal INcm of the second logic cell LC2 are connected to receive a common input.

With continued reference to Figure 3B, the logic control circuit 300 further comprises a fourth transistor mncm of N-type which is connected to both the first logic cell LC1 and the second logic cell LC2. The size of the fourth transistor mncm may be significantly smaller than the sum of the sizes of the transistors mn2a and mn2b of FIG.3A. In some embodiments, the size of the fourth transistor mncm may be equal to or smaller than one half of the sum of the sizes of the transistors mn2a and mn2b of FIG.3A. In the logic cell design, the transistors mn1a, mn2a, mn1b and mn2b of FIG.3A are of equal size. The fourth transistor mncm is in series with the third transistor mn1a of the first logic cell LC1 (indicated by the thick solid line in Figure 3B) and the third transistor mn1b of the second logic cell LC2 such that the first logic cell LC1 and the fourth transistor mncm form a first logic NAND gate, and the second logic cell LC2 and the fourth transistor mncm form a second logic NAND gate.

Figure 4B shows an embodiment 400 of the proposed logic control circuit. In this embodiment. In contrast to the prior art circuit shown in Figure 4A where eight transistors are used to form two logic NOR gates that generate three output combinations, the logic control circuit 400 is capable of providing the same output combinations with only seven transistors.

With reference to Figure 4B, the logic control circuit 400 comprises a first logic cell LC1' and a second logic cell LC2'. The first logic cell LC1' comprises a first input terminal INa and a second input terminal INcm both for receiving input digital signals and a first output terminal OUTa for outputting logic control signals. The first logic cell LC1' comprises a first transistor of N-type mn1a and a second transistor of N-type mn2a which are connected in parallel, and a third transistor of P-type mp2a. The drain terminals of the first transistor mn1a, the second transistor mn2a, and the third transistor mp2a are connected to the first output terminal OUTa. The second logic cell LC2' comprises a first input terminal INb and a second input terminal INcm both for receiving input digital signals and a second output terminal OUTb for outputting logic control signals. The second logic cell LC2' comprises a first transistor of N-type mn1b and a second transistor of N-type mn2b which are connected in parallel, and a third transistor of P-type mn2b. The drain terminals of the first transistor mn1b, the second transistor mn2b, and the third transistor mp2b are connected to the second output terminal OUTb. The second input terminal INcm of the first logic cell LC1' and the second input terminal INcm of the second logic cell LC2' are connected to receive a common input.

With continued reference to Figure 4B, the logic control circuit 400 further comprises a fourth transistor mpcm of P-type which is connected to both the first logic cell LC1' and the second logic cell LC2'. The size of the fourth transistor mpcm may be significantly smaller than the sum of the sizes of the transistors mp1a and mp1b of FIG.4A. In some embodiments, the size of the fourth transistor mpcm may be equal to or smaller than one half of the sum of the sizes of the transistors mp1a and mp1b of FIG.4A. In the logic cell design, the transistors mp1a, mp2a, mp1b and mp2b of FIG.4A are of equal size. The fourth transistor mpcm is in series with the third transistor mp2a of the first logic cell LC1' and the third transistor mp2b of the second logic cell LC2' (indicated by the thick solid line in Figure 4B) such that the first logic cell LC1' and the fourth transistor mpcm form a first logic NOR gate, and the second logic cell LC2' and the fourth transistor mpcm form a second logic NOR gate.

With reference to Figures 3B and 4B, the logic control circuits 300 and 400 each comprise three input terminals, namely INa, INb and INcm (a common input terminal), and two output terminals OUTa, OUTb. In operation, the input terminal INa may receive a first input digital signal and the input terminal INb may receive a second input digital signal which may be for example the inverted signal of the first input digital signal received by the terminal INa. The common input terminal INcm may receive a third digital input signal which may be for example a clock signal.

Although the embodiments 300, 400 described above relate specifically to logic NAND gates and logic NOR gates, it will be appreciated that the concept of simplifying a logic control circuit by merging two or more transistors into a common transistor may be equally applicable to a logic control circuit having two or more different logic gates either of a same type or of different types.

A different aspect of the present disclosure provides a digital-to-analog converter (DAC). The DAC may comprise a plurality of current steering switches configured to convert an input digital signal to an output analog signal and a control circuit which may comprise at least one proposed logic control circuit (e.g., 300 or 400). Based on the input digital signal, each of the at least one logic control circuit may be operable to output two logic control signals (e.g., OUTa, OUTb)) that are configured to control at least some (e.g., four) of the plurality of current steering switches to output the corresponding analog signal.

The plurality of current steering switches may be arranged into a plurality of differential switch pairs configured to steer a current from a current source to a load. The plurality of differential switch pairs may be arranged into one or more pairs of parallelly connected differential switch pairs (e.g., as shown in Figure 2). Each pair of parallelly connected differential switch pairs may be connected to a current source and operable to steer a current from the current source to an output of one of the two differential switch pairs. The two logic control signals of each of at least one logic control circuit may be configured to control one differential switch pair.

The description provided herein may be directed to specific implementations. It should be understood that the discussion provided herein is provided for the purpose of enabling a person with ordinary skill in the art to make and use any subject matter defined herein by the subject matter of the claims.

It should be intended that the subject matter of the claims is not limited to the implementations and illustrations provided herein, but include modified forms of those implementations including portions of implementations and combinations of elements of different implementations in accordance with the claims. It should be appreciated that in the development of any such implementation, as in any engineering or design project, numerous implementation-specific decisions should be made to achieve a developers' specific goals, such as compliance with system-related and business-related constraints, which may vary from one implementation to another. Moreover, it should be appreciated that such a development effort may be complex and time consuming, but would nevertheless be a routine undertaking of design, fabrication, and manufacture for those of ordinary skill having benefit of this invention.

Reference has been made in detail to various implementations, examples of which are illustrated in the accompanying drawings and figures. In the detailed description, numerous specific details are set forth to provide a thorough understanding of the invention provided herein. However, the invention provided herein may be practiced without these specific details. In some other instances, well-known methods, procedures, components, circuits, and networks have not been described in detail so as not to unnecessarily obscure details of the embodiments.

It should also be understood that, although the terms first, second, etc. may be used herein to describe various elements, these elements should not be limited by these terms. These terms are only used to distinguish one element from another. For example, a first element could be termed a second element, and, similarly, a second element could be termed a first element. The first element and the second element are both elements, respectively, but they are not to be considered the same element.

The terminology used in the description of the invention provided herein is for the purpose of describing particular implementations and is not intended to limit the invention provided herein. As used in the description of the invention provided herein and appended claims, the singular forms "a," "an," and "the" are intended to include the plural forms as well, unless the context clearly indicates otherwise. The term "and/or" as used herein refers to and encompasses any and all possible combinations of one or more of the associated listed items. The terms "includes," "including," "comprises," and/or "comprising," when used in this specification, specify a presence of stated features, integers, steps, operations, elements, and/or components, but do not preclude the presence or addition of one or more other features, integers, steps, operations, elements, components and/or groups thereof.

While the foregoing is directed to implementations of various techniques described herein, other and further implementations may be devised in accordance with the invention herein, which may be determined by the claims that follow. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A logic control circuit for controlling current steering switches of a digital-to-analog converter "DAC", comprising:
a first logic cell and a second logic cell, each comprising:
a first input terminal and a second input terminal both for receiving input digital signals and an output terminal for outputting a logic control signal;
a first transistor and a second transistor both of a first carrier type, wherein the first transistor and the second transistor are connected in parallel; and
a third transistor of a second carrier type, the second carrier type being opposite to the first carrier type;
wherein the drain terminals of the first transistor, the second transistor, and
the third transistor are connected to the output terminal; and
a fourth transistor of the second carrier type connected in series with the third transistor of the first logic cell and the third transistor of the second logic cell such that the first logic cell and the fourth transistor form a first logic gate, and the second logic cell and the fourth transistor form a second logic gate of the same type as the first logic gate.

2. A logic control circuit as claimed in claim 1, wherein
the first input terminal of the first logic cell is operable to receive a first input digital signal;
the first input terminal of the second logic cell is operable to receive a second input digital signal different than the first input digital signal; and
the second input terminal of the first logic cell and the second input terminal of the second logic cell are both operable to receive a third input digital signal.

3. A logic control circuit as claimed in claim 1 or 2, wherein the first input digital signal and the second input digital signal are of opposite logic states.

4. A logic control circuit as claimed in any preceding claim, wherein the gate terminals of the first transistor and the fourth transistor of the first logic cell are connected to the second input terminal of the first logic cell and the gate terminals of the first transistor and the fourth transistor of the second logic cell are connected to the second input terminal of the second logic cell; and the gate terminals of the second transistor and the third transistor of the first logic cell are connected to the first input terminal of the first logic cell and the gate terminals of the second transistor and the third transistor of the second logic cell are connected to the first input terminal of the second logic cell.

5. A logic control circuit as claimed in any preceding claim, wherein the drain terminal of the fourth transistor is connected to the source terminal of the third transistor of the first logic cell and to the source terminal of the third transistor of the second logic cell.

6. A logic control circuit as claimed in any preceding claim, wherein the first carrier type is P-type and the second carrier type is N-type.

7. A logic control circuit as claimed in claim 6, wherein the source terminal of the fourth transistor is connected to a ground terminal and the source terminals of the first transistor and the second transistor of the first logic cell, and the source terminals of the first transistor and the second transistor of the second logic cell are all connected to a positive power supply terminal.

8. A logic control circuit as claimed in claim 6 or 7, wherein the first logic gate and the second logic gate are both a NAND gate.

9. A logic control circuit as claimed in any of claims 1 to 5, wherein the first carrier type is N-type and the second carrier type is P-type.

10. A logic control circuit as claimed in claim 9, wherein the source terminal of the fourth transistor is connected to a positive power supply terminal and the source terminals of the first transistor and the second transistor of the first logic cell and the source terminals of the first transistor and the second transistor of the second logic cell are all connected to a ground terminal.

11. A logic control circuit as claimed in claim 9 or 10, wherein the first logic gate and the second logic gate are both a NOR gate.

12. A logic control circuit as claimed in any preceding claim, wherein the fourth transistor and the third transistors of the first logic cell and the second logic cell are of a same size.

13. A logic control circuit as claimed in any preceding claim, wherein the first transistor, the second transistor, the third transistor and the fourth transistor of each of the first logic cell and the second logic cell are all metal-oxide-semiconductor field-effect transistors (MOSFETs).

14. A digital-to-analog converter (DAC) comprising:
a plurality of current steering switches configured to convert an input digital signal to an output analog signal; and
a control circuit comprising at least one logic control circuit as claimed in any preceding claim, wherein based on the input digital signal, each of the at least one logic control circuit is operable to output two logic control signals configured to control at least some of the plurality of current steering switches to output the corresponding analog signal.

15. A DAC as claimed in claim 14, wherein the plurality of current steering switches is arranged into a plurality of differential switch pairs configured to steer a current from a current source to a load; and wherein the two logic control signals of each of at least one logic control circuit are configured to control one differential switch pair.
